# EUROPÄISCHE PATENTSCHRIFT

(11) **EP 1 929 546 B1**
(45) Veröffentlichungstag und Bekanntmachung des Hinweises auf die Patenterteilung: **15.02.2017**
(21) Anmeldenummer: 06791352.5
(22) Anmeldetag: 04.09.2006
(51) Int. Cl.: H01L 33/00, H01L 33/44, H01L 33/20, H01L 33/64

(54) **OPTOELEKTRONISCHER HALBLEITERCHIP UND HERSTELLUNGSVERFAHREN DAFÜR**
OPTOELECTRONIC SEMICONDUCTOR CHIP AND METHOD FOR MANUFACTURING THE SAME
PUCE SEMI-CONDUCTRICE OPTO-ÉLECTRONIQUE ET SON PROCÉDÉ DE FABRICATION

(30) Priorität: 30.09.2005 DE 102005047157; 21.12.2005 DE 102005061346
(43) Veröffentlichungstag der Anmeldung: 11.06.2008
(73) Patentinhaber: OSRAM Opto Semiconductors GmbH, 93055 Regensburg (DE)
(72) Erfinder: STREUBEL, Klaus, 93164 Laaber (DE)
(74) Vertreter: Epping - Hermann - Fischer
(86) Internationale Anmeldenummer: PCT/DE2006/001549
(87) Internationale Veröffentlichungsnummer: WO 2007/036190

(56) Entgegenhaltungen:
- EP-A- 1 536 466
- US-A1- 2003 189 215
- US-A1- 2004 104 390
- US-A1- 2005 176 162
- US-A1- 2005 205 875
- US-A1- 2006 145 164

## Beschreibung

Die Erfindung betrifft einen optoelektronischen Halbleiterchip sowie ein Herstellungsverfahren dafür.

Zum Befestigen eines vorgefertigten Halbleiterkörpers des Halbleiterchips auf einem separaten, vom Halbleiterkörper getrennt vorgefertigten Trägerkörper sind bei der Herstellung des Chips oftmals aufwendige Prozessschritte zur Befestigung des Trägerkörpers, etwa ein Aufbonden oder ein Auflöten des Trägerkörpers auf den Halbleiterkörper, erforderlich.

In den Druckschriften US 2004/0104390 A1 und US 2005/0205875 A1 sind Halbleiterchips beschrieben.

Eine Aufgabe der vorliegenden Erfindung ist es, einen, insbesondere hinsichtlich der Auskopplung von Strahlung, effizienten und vereinfacht herstellbaren optoelektronischen Halbleiterchip anzugeben.

Diese Aufgabe wird durch einen Halbleiterchip mit den Merkmalen des Patentanspruchs 1 sowie ein Verfahren mit den Merkmalen des Patentanspruchs 15 gelöst. Vorteilhafte Ausgestaltungen und Weiterbildungen der Erfindung sind Gegenstand der abhängigen Patentansprüche.

Ein erfindungsgemäßer optoelektronischer Halbleiterchip ist im Anspruch 1 angegeben. Der Halbleiterchip umfasst einen Dünnfilm-Halbleiterkörper, der eine Halbleiterschichtenfolge mit einem zur Strahlungserzeugung geeigneten aktiven Bereich aufweist, und eine auf der Halbleiterschichtenfolge ausgebildete, den Dünnfilm-Halbleiterkörper mechanisch stabilisierenden Trägerschicht.

Die auf der Halbleiterschichtenfolge ausgebildete Trägerschicht stabilisiert den Dünnfilm-Halbleiterkörper mechanisch. Auf einen separaten, gesondert vorgefertigten Trägerkörper auf dem die Halbleiterschichtenfolge für den Dünnfilm-Halbleiterkörper befestigt, zum Beispiel aufgebondet ist, kann so verzichtet werden. Durch Ausbilden, insbesondere Formen oder Aufschichten, der Trägerschicht auf der Halbleiterschichtenfolge für den Dünnfilm-Halbleiterkörper kann auf einen aufwändigen Bondprozess, in dem der separate Trägerkörper mit der Halbleiterschichtenfolge mechanisch stabil verbunden wird, verzichtet werden. Die Herstellung des optoelektronischen Halbleiterchips wird so gegenüber einem Halbleiterchip mit einer auf einem separaten Trägerkörper befestigten Halbleiterschichtenfolge vereinfacht. Da auf eine Befestigung der Halbleiterschichtenfolge auf einem separaten Trägerkörper verzichtet wird, kann der Halbleiterchip dementsprechend kostengünstiger gefertigt werden.

Als Dünnfilm-Halbleiterkörper ist im Rahmen der Erfindung ein Halbleiterkörper anzusehen, der von einem Herstellungssubstrat, auf dem die Halbleiterschichtenfolge für den Dünnfilm-Halbleiterkörper hergestellt ist, befreit ist oder bei dem das Herstellungssubstrat gedünnt ist. Das Herstellungssubstrat ist hierbei vorzugsweise derart gedünnt oder, insbesondere vollständig, entfernt, dass die mechanische Stabilität der Halbleiterschichtenfolge, vorzugsweise im wesentlichen alleine, durch die Trägerschicht gewährleistet ist. Auf eine mechanische Stabilisierung der Halbleiterschichtenfolge durch das Herstellungssubstrat kann aufgrund der auf der Halbleiterschichtenfolge ausgebildeten Trägerschicht mit Vorteil verzichtet werden.

Bei der Herstellung der Halbleiterschichtenfolge mittels epitaktischen Aufwachsens beispielsweise ist das Herstellungssubstrat durch das Aufwachssubstrat gegeben. Die Trägerschicht des Dünnfilm-Halbleiterkörpers ist demnach insbesondere vom Herstellungssubstrat verschieden. Ein Herstellungssubstrat für eine Halbleiterschichtenfolge unterliegt in der Regel hohen Anforderungen, zum Beispiel an die für das Aufwachsen dargebotene Kristallfläche des Aufwachssubstrats. Da die Trägerschicht des Dünnfilm-Halbleiterkörpers vom Herstellungssubstrat verschieden ist, kann die Trägerschicht vergleichsweise frei gewählt werden, ohne die für die Herstellung der Halbleiterschichtenfolge erforderlichen Eigenschaften aufweisen zu müssen. Ein Material für die Trägerschicht ist zweckmäßigerweise derart gewählt, dass die Trägerschicht auf der Halbleiterschichtenfolge ausbildbar, insbesondere formbar oder aufschichtbar, ist. Beispielsweise kann die Trägerschicht hinsichtlich optimierter thermischer Leitfähigkeit vergleichsweise frei gewählt werden. Die Effizienz des Halbleiterchips kann so, aufgrund der verbesserten thermischen Anbindung des aktiven Bereichs an ein, externes Wärmeleitelement vereinfacht gesteigert werden.

Ein erfindungsgemäßes Verfahren zur Herstellung eines optoelektronischen Halbleiterchips ist im Anspruch 15 angegeben. Bei dem Verfahren wird zunächst eine auf einem Substrat angeordnete Halbleiterschichtenfolge für einen Halbleiterkörper des Halbleiterchips bereitgestellt, wobei die Halbleiterschichtenfolge einen zur Strahlungserzeugung geeigneten aktiven Bereich aufweist. Daraufhin wird eine Trägerschicht auf der Halbleiterschichtenfolge ausgebildet, woraufhin das Substrat entfernt wird.

Das Substrat kann das Herstellungssubstrat der Halbleiterschichtenfolge oder ein vom Herstellungssubstrat verschiedenes Substrat umfassen. Anstatt das Substrat, zum Beispiel durch Ablösen, zu entfernen, kann es gegebenenfalls auch nur abgedünnt werden. Die Halbleiterschichtenfolge wird jedoch mit Vorteil im Wesentlichen nur durch die Trägerschicht gestützt, sodass ein Verzicht auf die Trägerschicht die Gefahr einer Schädigung der Halbleiterschichtenfolge des nunmehr ausgebildeten Dünnfilm-Halbleiterkörpers aufgrund fehlender mechanischer Unterstützung stark erhöhen würde.

Zum Entfernen des Substrats eignet sich beispielsweise Ätzen, ein Lasertrennverfahren oder Wasserstrahlschneiden. Für ein Abdünnen des Substrats ist Ätzen besonders geeignet.

Bevorzugt wird das Substrat im Wesentlichen vollständig entfernt. Vom Substrat überdeckte Elemente der Halbleiterschichtenfolge werden auf diese Weise für eine weitere Prozessierung vereinfacht zugänglich.

Bevorzugt wird die Trägerschicht auf der dem Substrat abgewandten Seite der Halbleiterschichtenfolge ausgebildet. Das Entfernen beziehungsweise das Abdünnen des Substrats wird so vereinfacht.

Die oben und im Folgenden beschriebenen Merkmale können sowohl für den erfindungsgemäßen optoelektronischen Halbleiterchip, als auch das erfindungsgemäße Verfahren herangezogen werden, da das Verfahren bevorzugt zur Herstellung eines erfindungsgemäßen Halbleiterchips eingesetzt wird.

In einer bevorzugten Ausgestaltung ist die Trägerschicht freitragend ausgebildet. Die Trägerschicht kann also ihr Eigengewicht und die Halbleiterschichtenfolge, sowie gegebenenfalls bis zur Entfernung oder Abdünnung des Substrats das Gewicht des Substrats tragen.

Bevorzugt weist die Trägerschicht eine Dicke größer oder gleich 10 µm, besonders bevorzugt größer oder gleich 20 µm oder größer oder gleich 50 µm auf. Weiterhin weist die Trägerschicht bevorzugt eine Dicke kleiner oder gleich 500 µm, besonders bevorzugt kleiner oder gleich 300 µm oder kleiner oder gleich 200 µm auf. Eine Dicke zwischen einschließlich 10 µm und einschließlich 500 µm, besonders bevorzugt zwischen einschließlich 50 µm und einschließlich 200 µm oder bis einschließlich 300 µm, hat sich für die Trägerschicht als besonders geeignet erwiesen.

Derartige Dicken sind zur mechanischen Stabilisierung der Halbleiterschichtenfolge besonders geeignet. Bevorzugt ist die Dicke der Trägerschicht möglichst gering gewählt, sodass die Halbleiterschichtenfolge zwar ausreichend mechanisch unterstützt wird, die Dicke der Trägerschicht aber nicht unnötig erhöht wird. Eine Trägerschicht mit einer vergleichsweise geringen Dicke kann sich durch einen vorteilhaft geringen thermischen Widerstand und demnach durch eine verbesserte thermische Anbindung an einen externen Wärmeanschluss auszeichnen. Weiterhin fallen Unterschiede in den thermischen Ausdehnungskoeffizienten der Trägerschicht zur Halbleiterschichtenfolge bei vergleichsweise geringer Dicke weniger ins Gewicht. Die Gefahr einer aufgrund unterschiedlicher thermischer Ausdehnungskoeffizienten hervorgerufenen Schädigung der Halbleiterschichtenfolge kann so verringert werden. Diesbezüglich ist auch eine Dicke der Trägerschicht zwischen einschließlich 50 µm und einschließlich 100 µm besonders geeignet.

In einer weiteren bevorzugten Ausgestaltung ist die Trägerschicht mechanisch stabil mit der Halbleiterschichtenfolge verbunden. Die Trägerschicht kann bereits mit einer derartigen mechanisch stabilen Verbindung auf der Halbleiterschichtenfolge für den Dünnfilm-Halbleiterkörper ausgebildet sein. Auf eine separate und zusätzliche, eine mechanisch stabile Verbindung vermittelnde Verbindungsschicht zwischen der Trägerschicht und der Halbleiterschichtenfolge, etwa eine Klebe-, Bond- oder Lotschicht, die eigens für die Ausbildung einer mechanisch stabilen Verbindung vorgesehen ist und vorzugsweise keine zusätzliche Funktion, etwa als Strahlung reflektierende Spiegelschicht, übernimmt, kann mit Vorteil verzichtet werden.

Die Trägerschicht wird mit sukzessiv, über die Dauer der Ausbildung der Trägerschicht wachsender Dicke auf der Halbleiterschichtenfolge ausgebildet. Hierzu eignet sich besonders ein Abscheideverfahren, mittels dessen die Trägerschicht auf der Halbleiterschichtenfolge abgeschieden wird. Ein Abscheideverfahren ist in der Regel zur Ausbildung dünner, nicht freitragender Schichten vorgesehen. Im Rahmen der Erfindung wird das Abscheideverfahren jedoch zur Ausbildung einer mechanisch tragfähigen Schicht eingesetzt. Über die Abscheidedauer kann die Schichtdicke der Trägerschicht eingestellt werden, wobei mit wachsender Abscheidedauer in der Regel auch die Schichtdicke zunimmt.

Bevorzugt wird die Trägerschicht mittels eines PVD- (PVD: Physical Vapor Deposition) oder CVD-Verfahrens (CVD: Chemical Vapor Deposition) auf der Halbleiterschichtenfolge abgeschieden. Besonders bevorzugt wird die Trägerschicht mittels Sputtern, insbesondere reaktivem Sputtern oder eines lasergestützten Verfahrens, wie eines Abscheideverfahrens unter Einsatz eines gepulsten Lasers, oder Bedampfen auf der Halbleiterschichtenfolge abgeschieden. Im Gegensatz zu Sputtern, bei dem aus einem Target oftmals mittels Ionenbeschuss Partikel der abzuscheidenden Substanz herausgelöst werden, wird bei einem lasergestützten Verfahren zum Herauslösen der Partikel ein Laser, insbesondere ein gepulster Laser, eingesetzt. Weiterhin kann sich auch ein plasma-assistiertes oder plasma-gestütztes PVD- oder CVD-Verfahren, etwa ein PECVD-Verfahren (PECVD: Plasma enhanced Chemical Vapor Deposition), für das Abscheiden der Trägerschicht eignen.

Im Gegensatz zu einem galvanischen Verfahren, das lediglich zur Aufbringung von Metallschichten geeignet ist, können mit den oben genannten Verfahren auch nichtmetallische Schichten ausgebildet werden. Die Trägerschicht des erfindungsgemäßen Halbleiterchips ist daher mit Vorteil nichtmetallisch ausgeführt und von einer Galvanikschicht verschieden.

Die Trägerschicht kann als polykristalline Schicht oder als amorphe Schicht ausgeführt sein. Beispielsweise kann die Trägerschicht als Keramikschicht ausgebildet sein. Bevorzugt enthält die Trägerschicht ein Aluminiumnitrid, wie AlN, oder ein Aluminiumoxid, wie AlO oder Al₂O₃. Derartige Materialien sind zur Ausbildung einer Trägerschicht, insbesondere mittels Sputterns, besonders geeignet. AlN zeichnet sich durch eine besonders hohe Wärmeleitfähigkeit aus.

Die Trägerschicht ist im Rahmen der Erfindung elektrisch isolierend, insbesondere als Isolator, ausgeführt

In einer weiteren bevorzugten Ausgestaltung ist die Trägerschicht für die im aktiven Bereich erzeugte Strahlung absorbierend ausgeführt.

Der Schwerpunkt bei der Ausbildung der Trägerschicht kann so vereinfacht auf die thermischen und die mechanisch tragenden Eigenschaften der Trägerschicht gelegt werden. Optische und/oder elektrische Eigenschaften können im Wesentlichen unberücksichtigt bleiben. Die Trägerschicht kann insbesondere aus einem elektrisch isolierenden und/oder für die im aktiven Bereich erzeugte Strahlung undurchlässigem Material bestehen.

Ferner ist die Trägerschicht bevorzugt von einem epitaktisch gewachsenen, z.B. in die Halbleiterschichtenfolge monolithisch integrierten, Quasisubstrat, das heißt einer bis zu einer mechanisch frei tragenden Dicke gewachsenen Halbleiterschicht, verschieden. Die kostenintensive Epitaxiezeit wird hierdurch reduziert und, die Herstellungskosten für den Halbleiterchip können vereinfacht in einem vertretbaren Rahmen gehalten werden.

In einer weiteren bevorzugten Ausgestaltung weist die Trägerschicht eine Mehrschichtstruktur auf. Die Freiheitsgrade bei der Ausbildung der Trägerschicht sind so erhöht. Beispielsweise kann der thermische Ausdehnungskoeffizient eines Mehrschichtstrukturverbunds vereinfacht aufgrund der erhöhten Variationsmöglichkeiten, die eine Mehrschichtstrüktur hinsichtlich Dicke und Zusammensetzung der Einzelschichten bietet, an den thermischen Ausdehnungskoeffizienten der Halbleiterschichtenfolge angepasst werden. Die Gefahr einer thermisch bedingten Schädigung der Halbleiterschichtenfolge beziehungsweise des aktiven Bereichs oder eines thermisch bedingten Ablösens der Halbleiterschichtenfolge von der Trägerschicht kann so vereinfacht verringert werden. Die Mehrschichtstruktur umfasst bevorzugt eine Mehrzahl nacheinander auf der Halbleiterschichtenfolge ausgebildeter Schichten, zum Beispiel zwei Schichten, die jeweils gemäß den obigen Ausführungen zur Trägerschicht ausgebildet sein und gegebenenfalls unterschiedliche Zusammensetzungen aufweisen können.

In einer weiteren bevorzugten Ausgestaltung ist zwischen der Trägerschicht und dem Dünnfilm-Halbleiterkörper eine metallhaltige Schicht, insbesondere eine metallbasierte oder legierungsbasierte Schicht, angeordnet. Die metallhaltige Schicht wird bevorzugt auf die dem Substrat abgewandte Seite der Halbleiterschichtenfolge vor dem Ausbilden der Trägerschicht aufgebracht.

Besonders bevorzugt ist die metallhaltige Schicht als metallische Schicht oder Legierungsschicht ausgeführt. Geeignete Metalle umfassen beispielsweise Al, Ag, Au, Pt oder eine Legierung, insbesondere mit mindestens einem der zuvor genannten Metalle, zum Beispiel AuGe oder AuSn.

Die metallhaltige Schicht kann als Spiegelschicht für in dem aktiven Bereich erzeugte Strahlung ausgebildet sein. Die Gefahr einer Absorption von der im aktiven Bereich erzeugten Strahlung in der Trägerschicht wird so verringert. Weiterhin kann mittels Reflexion an der Spiegelschicht die über die der Spiegelschicht abgewandte Oberfläche des Dünnfilm-Halbleiterkörpers aus dem Halbleiterchip ausgekoppelte Strahlungsleistung erhöht werden.

Die metallhaltige Schicht kann ferner als Kontaktschicht zur elektrischen Kontaktierung des Halbleiterchips ausgeführt oder dafür vorgesehen sein. Insbesondere kann die metallhaltige Schicht gegebenenfalls zugleich als Kontaktschicht und als Spiegelschicht ausgebildet sein. Ein externer elektrischer Anschluss des Halbleiterchips kann so vereinfacht direkt über die Kontaktschicht erfolgen. Beispielsweise kann die Kontaktschicht direkt mit einem Bonddraht verbunden werden. Auf das Vorsehen einer zusätzlichen Anschlussschicht kann verzichtet werden.

Ein Dünnfilm-Halbleiterchip, d.h. ein Halbleiterchip mit einem Dünnfilm-Halbleiterkörper, der auf der Trägerschicht angeordnet ist, kann sich weiterhin durch zumindest eines der folgenden Merkmale auszeichnen:
- an einer zu der Trägerschicht hin gewandten Hauptfläche einer strahlungserzeugenden Epitaxieschichtenfolge ist eine reflektierende Schicht, z. B. die metallhaltige Spiegelschicht, aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Halbleiterchip mit einer Spiegelschicht, z.B. der metallhaltigen Schicht, zwischen dem Dünnfilm-Halbleiterkörper und der Trägerschicht emittiert Strahlung im Wesentlichen über die der Trägerschicht abgewandte Oberfläche des Dünnfilm-Halbleiterkörpers. Ein derartiger Dünnfilm-Halbleiterchip kann eine Abstrahlcharakteristik aufweisen, die der cosinusförmigen Abstrahlcharakteristik eines Lambertschen Oberflächenstrahlers entspricht.

In einer weiteren bevorzugten Ausgestaltung enthält der Halbleiterchip, insbesondere die Halbleiterschichtenfolge oder der aktive Bereich, mindestens ein III-V-Verbindungshalbleitermaterial oder der Halbleiterchip, insbesondere die Halbleiterschichtenfolge oder der aktive Bereich, basiert auf III-V-Verbindungshalbleitermaterialien.

Verbindungshalbleitermaterialien, wie Nitrid-Verbindungshalbleiter, Phosphid-Verbindungshalbleiter oder Arsenid-Verbindungshalbleiter, sind zur Ausbildung einer Halbleiterschichtenfolge für effiziente Halbleiterchips, insbesondere von aktiven Bereichen hoher Quanteneffizienz besonders geeignet.

Im Zweifel bedeutet "basiert auf Nitrid-Verbindungshalbleitermaterial", dass zumindest ein Teil der Halbleiterschichtenfolge ein Nitrid/V-Verbindungshalbleitermaterial umfasst, vorzugsweise AlₙGaₘIn₁₋ₙ₋ₘN, wobei 0 ≤ n ≤ 1, 0 ≤ m ≤ 1 und n+m ≤ 1, vorzugsweise mit m≠0 und/oder n≠0. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Äquivalent bedeutet vorliegend "basiert auf Phosphid-Verbindungshalbleitermaterial" im Zweifel, dass zumindest ein Teil der Halbleiterschichtenfolge ein Phosphid/V-Verbindungshalbleitermaterial umfasst, vorzugsweise AlₙGaₘIn₁₋ₙ₋ₘP, wobei 0 ≤ n ≤ 1, 0 ≤ m ≤ 1 und n+m ≤ 1, vorzugsweise mit m≠0 und/oder n≠0. Dabei muss auch dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘP-Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Ebenfalls äquivalent bedeutet vorliegend "basiert auf Arsenid-Verbindungshalbleitermaterial" im Zweifel, dass zumindest ein Teil der Halbleiterschichtenfolge ein Arsenid/V-Verbindungshalbleitermaterial umfasst, vorzugsweise AlₙGaₘIn₁₋ₙ₋ₘAs, wobei 0 ≤ n ≤ 1, 0 ≤ m ≤ 1 und n+m ≤ 1, vorzugsweise mit m≠0 und/oder n≠0. Auch dieses Material muss nicht zwingend eine mathematisch exakte Zusammensetzung nach obiger Formel aufweisen und kann ein oder mehrere Dotierstoffe sowie zusätzliche Bestandteile aufweisen, die die charakteristischen physikalischen Eigenschaften des AlₙGaₘIn₁₋ₙ₋ₘAs-Materials im Wesentlichen nicht ändern. Wiederum beinhaltet obige Formel der Einfachheit halber jedoch nur die wesentlichen Bestandteile des Kristallgitters (Al, Ga, In, As), auch wenn diese teilweise durch geringe Mengen weiterer Stoffe ersetzt sein können.

Nitrid-Verbindungshalbleitermaterial eignet sich besonders für einen aktiven Bereich zur Erzeugung ultravioletter bis blauer Strahlung, Phosphid-Verbindungshalbleitermaterial besonders für einen aktiven Bereich zur Erzeugung gelber bis roter Strahlung und Arsenid-Verbindungshalbleitermaterial besonders zur Erzeugung infraroter Strahlung. Bevorzugt ist der Halbleiterchip zur Erzeugung sichtbaren Lichts ausgebildet.

In einer weiteren bevorzugten Ausgestaltung ist der Halbleiterchip als resonatorfreier Chip zur Erzeugung inkohärenter Strahlung ausgeführt, z.B. als LED-Chip. Im Gegensatz zu Chips mit Resonator, etwa einem Laser, kann so vereinfacht im Wesentlichen eine gesamte Oberfläche des Halbleiterchips als Emissionsoberfläche genutzt oder der Herstellungsaufwand verringert werden.

In einer weiteren bevorzugten Ausgestaltung wird das erfindungsgemäße Verfahren zur gleichzeitigen Herstellung einer Mehrzahl von Halbleiterchips im Waferverbund durchgeführt beziehungsweise das Verfahren ist zur Durchführung im Waferverbund geeignet und vorzugsweise vorgesehen.

Hierzu wird für das erfindungsgemäße Verfahren bevorzugt eine für die Ausbildung einer Mehrzahl von Halbleiterkörpern vorgesehene Halbleiterschichtstruktur, die auf einem Substrat angeordnet ist, bereitgestellt. Da eine Mehrzahl von Halbleiterchips im Waferverbund hergestellt werden kann, können die Herstellungskosten eines einzelnen Halbleiterchips verringert werden. Eine gemäß dem Verfahren auf der Halbleiterschichtstruktur ausgebildete Trägerschicht kann demnach als Trägerschicht für einen Halbleiterwafer, dessen Halbleiterschichtstruktur für die Ausbildung einer Mehrzahl von Halbleiterkörpern vorgesehen ist, eingesetzt werden.

Eine die Trägerschicht eines mittels des Verfahrens hergestellten Halbleiterchips begrenzende Seitenfläche kann bei der Vereinzelung des Halbleiterchips aus dem Waferverbund gebildet sein.

Weiterhin ist die Trägerschicht bevorzugt als äußerste Seitenflächen des Halbleiterkörpers nicht umgreifende Schicht ausgeführt. Ferner ist die Trägerschicht, insbesondere auf ihrer dem Halbleitermaterial abgewandten und/oder ihrer dem Halbleitermaterial zugewandten Seite, bevorzugt eben ausgeführt.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.
Figur 1 zeigt anhand von schematischen Schnittansichten in den Figuren 1A bis 1F Zwischenschritte für ein Ausführungsbeispiel eines erfindungsgemäßen Verfahrens zur Herstellung einer Mehrzahl optoelektronischer Halbleiterchips im Waferverbund und
Figur 2 zeigt eine schematische Schnittansicht eines Ausführungsbeispiels eines erfindungsgemäßen optoelektronischen Halbleiterchips.

Gleiche, gleichartige und gleich wirkende Elemente sind in den Figuren mit gleichen Bezugszeichen versehen.

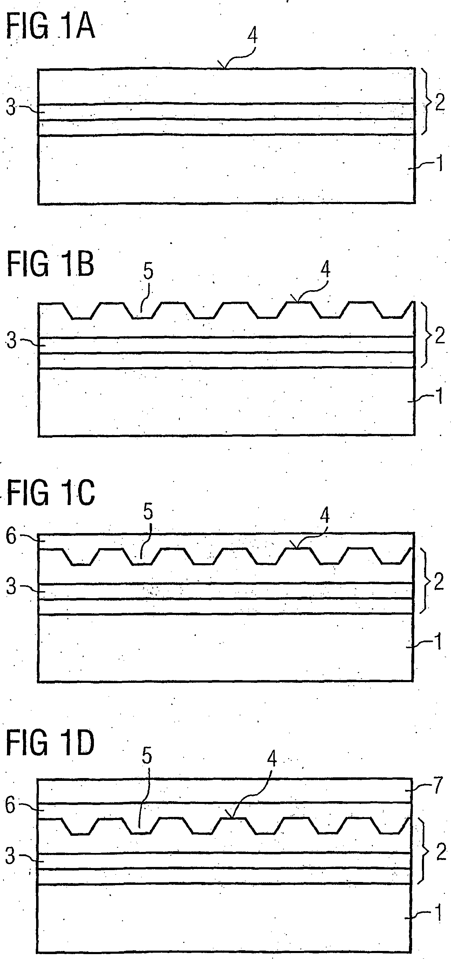

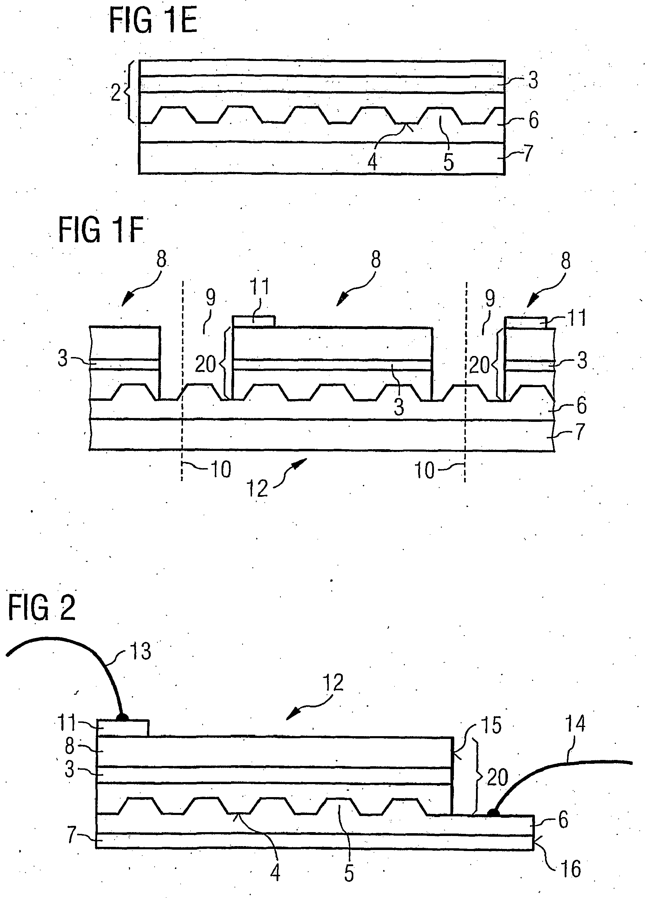

Figur 1 zeigt anhand von schematischen Schnittansichten in den Figuren 1A bis 1F Zwischenschritte für ein Ausführungsbeispiel eines erfindungsgemäßen Verfahrens zur Herstellung einer Mehrzahl optoelektronischer Halbleiterchips im Waferverbund.

Zunächst wird im Waferverbund eine auf einem Substrat 1 angeordnete Halbleiterschichtstruktur 2, die einen zur Strahlungserzeugung geeigneten aktiven Bereich 3 aufweist, bereitgestellt, Figur 1A.

Das Substrat 1 enthält beispielsweise GaAs und die Halbleiterschichtstruktur ist bevorzugt epitaktisch auf dem Substrat 1 gewachsen, sodass das Substrat 1 das Aufwachssubstrats der Halbleiterschichtstruktur bilden kann. Der aktive Bereich 3 und/oder die Halbleiterschichtstruktur 2 basiert hierbei bevorzugt auf AlₙGaₘIn₁₋ₙ₋ₘP, insbesondere mit m≠0 und/oder n≠0, und besonders bevorzugt AlₓGa₁₋ₓAs, mit 0≤x≤1, vorzugsweise mit x>0. Ein GaAs-Substrat ist für das Aufwachsen eines aktiven Bereichs oder einer Halbleiterschichtstruktur auf InGaAlP-Basis, die auch zusätzlich Elemente auf AlGaAs-Basis enthalten kann, besonders geeignet.

Der aktive Bereich 3 umfasst bevorzugt eine Doppelheterostruktur, oder eine Ein- oder Mehrfachquantentopfstruktur. Derartige Strukturen sind aufgrund der hohen erzielbaren internen Quanteneffizienzen zur effizienten Strahlungserzeugung besonders geeignet. Die Bezeichnung Quantentopfstruktur beinhaltet keine Angabe über die Dimensionalität. Sie umfasst somit u. a. Quantentröge, Quantendrähte und Quantenpunkte und jede Kombination dieser Strukturen.

Nachfolgend wird die dem Substrat 1 abgewandte Oberfläche 4 der Halbleiterschichtstruktur 2 mit einer Oberflächenstruktur 5 versehen, Figur 1B. Diese Struktur kann in einer, zum Beispiel p-leitenden, Halbleiterschicht, die die Halbleiterschichtstruktur 2 bevorzugt auf der dem Substrat 1 abgewandten Seite begrenzt, ausgebildet werden. Die Oberflächenstruktur 5 kann mittels Ätzen, zum Beispiel nass- oder trockenchemischem Ätzen, unter Einsatz einer geeignet ausgebildeten Maske, in der Halbleiterschichtstruktur 2 erzeugt werden. Hierzu wird bevorzugt eine Maske auf der Oberfläche 4 ausgebildet, die gemäß der gewünschten Oberflächenstruktur ausgespart ist. Daraufhin kann die Oberflächenstruktur durch die Aussparungen der Maske erzeugt und die Maske nachfolgend wieder entfernt werden.

Gegebenenfalls kann die Oberflächenstruktur auch aus Aufrauung, zum Beispiel mittels eines Sandstrahlverfahrens, erzeugt werden. Hierbei wird bevorzugt die gesamte Oberfläche einer Aufrauung unterzogen. Auf eine Maske zur Definition der Struktur kann hierbei verzichtet werden.

Die Oberflächenstruktur 5 kann beispielsweise eine Mehrzahl, vorzugsweise äquidistant angeordneter, Vertiefungen, zum Beispiel in der Form von Pyramidenstümpfen, Kegelstümpfen oder Mikroprismen, umfassen. Eine Vertiefung verbreitert sich in lateraler Richtung bevorzugt mit, insbesondere parallel zum aktiven Bereich, wachsender Entfernung von dem aktiven Bereich.

Mittels der Oberflächenstruktur 5 kann im herzustellenden Halbleiterchip vereinfacht eine Reflexion von Strahlung seitens der strukturierten Oberfläche mit einer breiten Verteilung der Reflexionswinkel erzielt werden. Die Wahrscheinlichkeit einer fortgesetzten Totalreflexion von im aktiven Bereich 3 erzeugter Strahlung im Halbleitermaterial wird aufgrund der Oberflächenstruktur verringert, wodurch die Auskoppeleffizienz von Strahlung aus dem Halbleitermaterial der hergestellten Halbleiterchips erhöht wird.

Daraufhin wird eine metallhaltige Schicht 6 auf die dem Substrat 1 abgewandte Seite des Verbunds aufgebracht, zum Beispiel aufgedampft (Figur 1C). Die metallhaltige Schicht 6 ist bevorzugt als Metallisierung, zum Beispiel aus Au, oder Legierung, zum Beispiel aus AuGe, ausgeführt. Die metallhaltige Schicht 6 ist weiterhin bevorzugt zumindest bereichsweise, vorzugsweise im wesentlichen vollflächig, mit dem aktiven Bereich 3 elektrisch leitend verbunden und kann so vereinfacht als Kontaktschicht mittels derer die herzustellenden Halbleiterchips elektrisch kontaktierbar sind, eingesetzt werden. Insbesondere kann die metallhaltige Schicht direkt auf das Halbleitermaterial aufgebracht sein.

Weiterhin kann die metallhaltige Schicht 6 als Spiegelschicht, die im aktiven Bereich erzeugte Strahlung in das Halbleitermaterial zurück reflektiert, ausgeführt sein. Ferner ragt die metallhaltige Schicht bevorzugt in die Oberflächenstruktur hinein.

Gegebenenfalls kann die metallhaltige Schicht 6 auch eine Mehrzahl von Schichten, von denen ein Teil die Kontaktschicht bildet und ein weiterer Teil die Spiegelschicht bildet, ausgeführt sein (nicht dargestellt). Die Einzelschichten können hierbei vereinfacht auf eine Funktion bei der elektrischen Kontaktierung beziehungsweise zur Reflexion von Strahlung optimiert ausgeführt sein.

Gegebenenfalls kann zwischen der metallhaltigen Schicht 6 und dem Halbleitermaterial auch eine elektrische Isolationsschicht, zum Beispiel ein Siliziumnitrid, wie SiN, enthaltend, angeordnet sein (nicht dargestellt). Diese Isolationsschicht kann als dielektrische Spiegelschicht dienen. Die Isolationsschicht ist für eine elektrisch leitende Verbindung der metallhaltigen Schicht 6 zum aktiven Bereich bevorzugt in Kontaktstellen ausgespart.

Die metallhaltige Schicht 6 weist bevorzugt eine derart große Dicke auf, dass die dem aktiven Bereich 3 abgewandte Oberfläche der metallhaltigen Schicht im Wesentlichen eben ist. Die Oberflächenstruktur 5 kann demgemäß mittels der metallhaltigen Schicht derart aufgefüllt werden, dass auf der der Oberflächenstruktur 5 abgewandten Seite der metallhaltigen Schicht eine ebene Fläche ausgebildet wird.

Nachfolgend wird auf der metallhaltigen Schicht 6 eine elektrisch isolierende Trägerschicht 7 abgeschieden, Figur 1D.

Die Trägerschicht 7 kann mittels Sputtern auf dem Verbund ausgebildet werden. Als Material für die Trägerschicht ist hierzu ein Aluminiumnitrid, wie AlN, oder ein Aluminiumoxid, wie AlO oder Al₂O₃, besonders geeignet. Die Trägerschicht 7 kann weiterhin insbesondere als amorphe oder polykristalline Schicht, z.B. als Keramikschicht, ausgeführt sein. Aluminiumoxid und insbesondere Aluminiumnitrid zeichnen sich durch vorteilhaft hohe Wärmeleitfähigkeiten aus, sodass die bei der Strahlungserzeugung anfallende Wärme vereinfacht vom Halbleitermaterial abgeleitet werden kann. Gegebenenfalls kann das Sputtern reaktiv und/oder lasergestützt erfolgen. Aluminiumnitrid beispielsweise ist ein elektrischer Isolator, sodass die elektrische Kontaktierung des aktiven Bereichs 3 bevorzugt mittels der metallhaltigen Schicht 6 erfolgt.

Die Trägerschicht 7 ist freitragend und insbesondere bevorzugt im wesentlichen beidseitig eben ausgebildet, sodass sie ihr Eigengewicht trägt und die Halbleiterschichtstruktur 2 mechanisch stabilisiert. Hierzu ist eine Dicke der Trägerschicht zwischen einschließlich 50 µm und 200 µm, insbesondere zwischen einschließlich 50 µm und 100 µm, auch im Hinblick auf eine gute Wärmeableitung vom aktiven Bereich besonders geeignet. Da die metallhaltige Schicht als Spiegelschicht ausgeführt sein kann, kann die Trägerschicht 7 gegebenenfalls auch für die zu erzeugende Strahlung absorbierend ausgeführt sein, ohne die Gefahr einer tatsächlichen Absorption von Strahlung in der Trägerschicht 7 wesentlich zu erhöhen. Die Trägerschicht kann also strahlungsundurchlässig, insbesondere aus einem strahlungsundurchlässigen Material oder einer entsprechenden Materialzusammensetzung, ausgeführt sein.

Je nach dem Material der Trägerschicht können für das Ausbilden, insbesondere Aufschichten, der Trägerschicht außer Sputtern auch andere Abscheideverfahren, wie ein CVD- oder PVD-Verfahren, zum Beispiel Bedampfen, eingesetzt werden. Bevorzugt werden Verfahren eingesetzt, die für das Ausbilden einer amorphen oder polykristallinen Schicht, insbesondere einer Keramikschicht, geeignet sind. Auch ein plasma-assistiertes Abscheideverfahren, etwa ein PECVD-Verfahren, kann zum Aufbringen der Trägerschicht geeignet sein.

Weiterhin kann auch eine Mehrschichtstruktur, vorzugsweise mit Einzelschichten verschiedener Zusammensetzung, z.B. einer Aluminiumnitrid- und einer Aluminiumoxid-Schicht, als Trägerschicht 7 dienen, wodurch die Freiheitsgrade bei der Ausgestaltung der Trägerschicht 7, insbesondere der Anpassung des thermischen Ausdehnungskoeffizienten der Trägerschicht an denjenigen der Halbleiterschichtstruktur erhöht sind. Mit steigender Schichtzahl wächst jedoch in der Regel auch der thermische Widerstand der Trägerschicht, sodass eine möglichst geringe Anzahl an Einzelschichten, z.B. fünf oder weniger, bevorzugt ist. Besonders bevorzugt umfasst die Trägerschicht genau eine Einzelschicht.

Da die Trägerschicht 7 erst im Verbund auf dem aktiven Bereich.3 beziehungsweise, insbesondere unmittelbar, auf der metallhaltigen Schicht 6 ausgebildet wird, kann auf einen Bondprozess, zum Beispiel ein Auflöten oder Aufkleben eines separat, außerhalb des Waferverbunds vorgefertigten Trägerkörpers auf die Halbleiterschichtstruktur 2, verzichtet und das Herstellungsverfahren in der Folge vereinfacht werden.

In einem nachfolgend durchgeführten Verfahrensschritt, Figur 1E, wird das Substrat 1 von der Halbleiterschichtstruktur 2 entfernt. Beispielsweise wird das Substrat 1 weggeätzt oder, etwa mittels eines Lasertrennverfahrens, abgelöst.

Die mechanische Stabilität des Waferverbunds mit der auf der Trägerschicht 7 angeordneten Halbleiterschichtstruktur 2 wird, insbesondere alleinig, durch die freitragende Trägerschicht gewährleistet.

Nachfolgend wird die Halbleiterschichtstruktur 2 derart strukturiert, dass eine Mehrzahl von auf der Trägerschicht 7 angeordneten Halbleiterkörpern 8, die bevorzugt jeweils durch einen Zwischenraum 9 voneinander beabstandet sind, ausgebildet wird. Die Halbleiterkörper 8, die aus der Halbleiterschichtstruktur 2 nach deren Strukturierung hervorgehen, weisen jeweils eine Halbleiterschichtenfolge 20 mit einem zur Strahlungserzeugung geeigneten aktiven Bereich 3 auf. Diese Strukturierung kann mittels Ätzen unter Einsatz einer geeigneten Maske erfolgen, die nachfolgend wieder entfernt wird.

Bevorzugt wird von der der Trägerschicht 7 abgewandten Seite des Verbundes her derart strukturiert, dass die metallhaltige Schicht 6 freigelegt wird. Da das Aufwachssubstrat von der Halbleiterschichtstruktur 2 entfernt ist, sind die Halbleiterkörper 8 als Dünnfilm-Halbleiterkörper ausgeführt.

Entlang der Linien 10, die im Bereich der Zwischenräume 9 verlaufen, können nachfolgend optoelektronische Halbleiterchips 12 aus dem Waferverbund vereinzelt werden. Das Vereinzeln kann beispielsweise durch Sägen im Bereich der Zwischenräume erfolgen. Die optoelektronischen Halbleiterchips umfassen bevorzugt jeweils genau einen Halbleiterkörper 8. Das Vereinzeln erfolgt insbesondere durch die Trägerschicht 7 und/oder die metallhaltige Schicht 6.

Vor dem Vereinzeln werden auf der der Trägerschicht 7 abgewandten Seite für die Halbleiterkörper 8 elektrische Kontakte 11 auf den Verbund aufgebracht, zum Beispiel aufgedampft. Bevorzugt sind die Kontakte 11 als Kontaktmetallisierungen ausgeführt.

Figur 2 zeigt einen gemäß dem in Figur 1 beschriebenen Verfahren herstellbaren optoelektronischen Halbleiterchip 12. Der Halbleiterchip 12 entspricht im wesentlichen einem durch Vereinzelung aus dem in Figur 1F gezeigten Verbund hervorgehenden Halbleiterchip mit einem Dünnfilm-Halbleiterkörper 8, sodass die im Zusammenhang mit Figur 1 beschriebenen Merkmale auch für den Halbleiterchip gemäß Figur 2 herangezogen werden können.

Im Unterschied zum Verbund in Figur 1F ist der Kontakt 11 für die elektrische Kontaktierung des Halbleiterchips, beispielsweise mit den Anschlussleitern eines Gehäuses, in das der Halbleiterchip 12 eingesetzt wird, mit einem Bonddraht 13 elektrisch leitend verbunden. Die metallhaltige Schicht 6 ist mit einem weiteren Bonddraht 14, insbesondere direkt, elektrisch leitend verbunden. Über den Kontakt 11 und die als Kontaktschicht dienende metallhaltige Schicht 6 ist der optoelektronische Halbleiterchip 12 elektrisch anschließbar. Die metallhaltige Schicht 6 und/oder der Kontakt 11 ist hierzu elektrisch leitend mit dem aktiven Bereich 3 verbunden. Um die elektrische Kontaktierung der metallhaltigen Schicht 6, etwa mittels des Bonddrahts 14, zu erleichtern, ragt die metallhaltige Schicht 6 bevorzugt lateral über eine den Halbleiterkörper 8 begrenzende Seitenfläche 15 hinaus. Bevorzugt ragt auch die Trägerschicht über die Seitenfläche 15 hinaus. Die metallhaltige Schicht 6 wird so mit Vorteil auch in dem lateral überstehenden Bereich durch die Trägerschicht 7 mechanisch stabilisiert.

Weiterhin kann eine den Halbleiterchip 12 lateral begrenzende Seitenfläche 16 beim Vereinzeln ausgebildet sein. Diese Seitenfläche ist bevorzugt zumindest teilweise durch die Trägerschicht 7 und/oder die metallhaltige Schicht 6 gebildet. Weiterhin ist die Seitenfläche 16 vom Halbleiterkörper 8, insbesondere dessen Seitenfläche 15, lateral beabstandet.

Die metallhaltige Schicht 6 reflektiert im aktiven Bereich erzeugte Strahlung im Betrieb des Halbleiterchips 12. Aufgrund der Oberflächenstruktur 5 sind die Reflexionswinkel bei der Reflexion an der metallhaltigen Schicht gegenüber einer Reflexion an einer ebenen Fläche vorteilhaft breit gestreut, wodurch die Gefahr einer fortgesetzten Totalreflexion von Strahlung im Halbleiterkörper 8 und dementsprechend verminderte Auskopplung von Strahlung aus dem Halbleiterkörper 8 verringert wird. Die Auskoppeleffizienz des Halbleiterchips wird in der Folge erhöht.

Weiterhin ist der Halbleiterchip 12 bevorzugt als resonatorfreier LED-Chip zur Erzeugung inkohärenter Strahlung ausgebildet. Ein derartiger Chip ist besonders einfach und kostengünstig herstellbar.

Über die elektrisch isolierende, thermisch jedoch gut leitfähige Trägerschicht 7, z.B. aus AlN, kann im Betrieb des Halbleiterchips 12 in dem aktiven Bereich 3 anfallende Wärme zuverlässig aus dem Halbleitermaterial abgeführt werden.

Diese Patentanmeldung beansprucht die Prioritäten der deutschen Patentanmeldungen DE 10 2005 047 157.9 vom 30. September 2005 und DE 10 2005 061 346.2 vom 21. Dezember 2005.

Die Erfindung ist nicht durch die Beschreibung anhand der Ausführungsbeispiele sondern durch die Patentansprüche beschränkt.

## Patentansprüche

1. Optoelektronischer Halbleiterchip (12) mit einem Dünnfilm-Halbleiterkörper (8), wobei der Dünnfilm-Halbleiterkörper eine Halbleiterschichtenfolge (2, 20) mit einem zur Strahlungserzeugung geeigneten aktiven Bereich (3) umfasst, wobei die Halbleiterschichtenfolge epitaktisch auf einem Aufwachssubstrat (1) gewachsen ist und das Aufwachssubstrat gedünnt oder von der Halbleiterschichtenfolge entfernt ist, und mit einer auf der Halbleiterschichtenfolge ausgebildeten, den Dünnfilm-Halbleiterkörper mechanisch stabilisierenden Trägerschicht (7), wobei die Trägerschicht elektrisch isolierend ist, **dadurch gekennzeichnet, dass**
die Trägerschicht eine auf der Halbleiterschichtenfolge abgeschiedene Trägerschicht ist.

2. Halbleiterchip nach Anspruch 1
**dadurch gekennzeichnet, dass**
die Trägerschicht (7) freitragend ausgebildet ist.

3. Halbleiterchip nach Anspruch 1 oder 2
**dadurch gekennzeichnet, dass**
die Trägerschicht (7) eine Dicke zwischen einschließlich 10 µm und einschließlich 500 µm, vorzugsweise zwischen einschließlich 50 µm und einschließlich 200 µm, aufweist.

4. Halbleiterchip nach mindestens einem der vorhergehenden Ansprüche,
**dadurch gekennzeichnet, dass**
die Trägerschicht (7) von dem Aufwachssubstrat (1) verschieden ist, auf dem die Halbleiterschichtenfolge (2, 20) für den Dünnfilm-Halbleiterkörper (8) epitaktisch gewachsen ist.

5. Halbleiterchip nach mindestens einem der vorhergehenden Ansprüche,
**dadurch gekennzeichnet, dass**
die Trägerschicht (7) für die im aktiven Bereich (3) erzeugte Strahlung absorbierend ist.

6. Halbleiterchip nach mindestens einem der vorhergehenden Ansprüche,
**dadurch gekennzeichnet, dass**
die Trägerschicht (7) als Keramikschicht, polykristalline Schicht oder amorphe Schicht ausgeführt ist.

7. Halbleiterchip nach mindestens einem der vorhergehenden Ansprüche,
**dadurch gekennzeichnet, dass**
die Trägerschicht (7) ein Aluminiumnitrid oder ein Aluminiumoxid enthält.

8. Halbleiterchip nach mindestens einem der vorhergehenden Ansprüche,
**dadurch gekennzeichnet, dass**
die Trägerschicht (7) eine Mehrschichtstruktur aufweist.

9. Halbleiterchip nach mindestens einem der vorhergehenden Ansprüche,
**dadurch gekennzeichnet, dass**
zwischen der Trägerschicht (7) und dem Dünnfilm-Halbleiterkörper (8) eine metallhaltige Schicht (6), insbesondere eine metall- oder legierungsbasierte Schicht, angeordnet ist.

10. Halbleiterchip nach Anspruch 9,
**dadurch gekennzeichnet, dass**
die metallhaltige Schicht (6) als Spiegelschicht für in dem aktiven Bereich (3) erzeugte Strahlung ausgebildet ist.

11. Halbleiterchip nach Anspruch 9 oder 10,
**dadurch gekennzeichnet, dass**
die metallhaltige Schicht (6) als Kontaktschicht zur elektrischen Kontaktierung des Halbleiterchips (12) ausgeführt ist.

12. Halbleiterchip nach mindestens einem der vorhergehenden Ansprüche,
**dadurch gekennzeichnet, dass**
der Halbleiterchip (10), insbesondere die Halbleiterschichtenfolge (2, 20) und/oder der aktive Bereich (3), mindestens ein III-V-Verbindungshalbleitermaterial enthält oder auf III-V-Verbindungshalbleitermaterialien basiert.

13. Halbleiterchip nach mindestens einem der vorhergehenden Ansprüche,
**dadurch gekennzeichnet, dass**
der Halbleiterchip (12) als resonatorfreier Chip zur Erzeugung inkohärenter Strahlung ausgeführt ist.

14. Halbleiterchip nach mindestens einem der vorhergehenden Ansprüche,
**dadurch gekennzeichnet, dass**
der Halbleiterchip (12) als LED-Chip ausgeführt ist.

15. Verfahren zur Herstellung eines optoelektronischen Halbleiterchips (12) mit den Schritten:
- Bereitstellen einer auf einem Substrat (1) angeordneten Halbleiterschichtenfolge (2, 20) für einen Halbleiterkörper (8) des Halbleiterchips, wobei die Halbleiterschichtenfolge einen zur Strahlungserzeugung geeigneten aktiven Bereich (3) aufweist,
- Ausbilden einer elektrisch isolierenden Trägerschicht (7) auf der Halbleiterschichtenfolge und
- Entfernen des Substrats,
**dadurch gekennzeichnet, dass**
die Trägerschicht (7) mittels eines Abscheideverfahrens auf der Halbleiterschichtenfolge (2, 20) abgeschieden wird.

16. Verfahren nach Anspruch 15,
**dadurch gekennzeichnet, dass**
die Trägerschicht (7) auf der dem Substrat (1) abgewandten Seite der Halbleiterschichtenfolge (2, 20) abgeschieden wird.

17. Verfahren nach Anspruch 15 oder 16,
**dadurch gekennzeichnet, dass**
die Trägerschicht (7) mittels eines PVD-Verfahrens oder eines CVD-Verfahrens auf der Halbleiterschichtenfolge (2, 20) abgeschieden wird.

18. Verfahren nach mindestens einem der Ansprüche 15 bis 17,
**dadurch gekennzeichnet, dass**
die Trägerschicht (7) mittels Sputtern, insbesondere reaktivem Sputtern oder eines lasergestützten Verfahrens, wie eines Abscheideverfahrens unter Einsatz eines gepulsten Lasers, oder Bedampfen auf der Halbleiterschichtenfolge (2, 20) abgeschieden wird.

19. Verfahren nach mindestens einem der Ansprüche 15 bis 18,
**dadurch gekennzeichnet, dass**
auf die dem Substrat (1) abgewandte Seite der Halbleiterschichtenfolge (2, 20) vor dem Ausbilden der Trägerschicht (7) eine metallhaltige Schicht (6), insbesondere eine metall- oder legierungsbasierte Schicht, aufgebracht wird.

20. Verfahren nach mindestens einem der Ansprüche 15 bis 19,
**dadurch gekennzeichnet, dass**
das Substrat (1) das Aufwachssubstrat umfasst, auf dem die
Halbleiterschichtenfolge (2, 20) epitaktisch gewachsen ist.

21. Verfahren nach mindestens einem der Ansprüche 15 bis 20,
**dadurch gekennzeichnet, dass**
das Verfahren zur gleichzeitigen Herstellung einer Mehrzahl von Halbleiterchips (12) im Waferverbund durchgeführt wird.

22. Verfahren nach Anspruch 21,
**dadurch gekennzeichnet, dass**
eine die Trägerschicht (7) eines mittels des Verfahrens hergestellten Halbleiterchips (12) begrenzende Seitenfläche (16) bei der Vereinzelung des Halbleiterchips aus dem Waferverbund gebildet ist.

23. Verfahren nach mindestens einem der Ansprüche 15 bis 22,
**dadurch gekennzeichnet, dass**
ein Halbleiterchip (12) gemäß einem der Ansprüche 1 bis 14 mittels des Verfahrens herstellbar oder hergestellt ist.

## Claims

1. Optoelectronic semiconductor chip (12) comprising a thin-film semiconductor body (8), where the thin-film semiconductor body comprises a semiconductor layer sequence (2, 20) having an active region (3) suitable for generating radiation, where the semiconductor layer sequence is grown epitaxially on a growth substrate (1) and the growth substrate is thinned or removed from the semiconductor layer sequence, and comprising a carrier layer (7), which is formed on the semiconductor layer sequence and mechanically stabilizes the thin-film semiconductor body, where the carrier layer is electrically insulating,
**characterized in that** the carrier layer is a carrier layer deposited on the semiconductor layer sequence.

2. Semiconductor chip according to Claim 1,
**characterized in that**
the carrier layer (7) is formed in self-supporting fashion.

3. Semiconductor chip according to Claim 1 or 2,
**characterized in that**
the carrier layer (7) has a thickness of between 10 µm and 500 µm inclusive, preferably between 50 µm and 200 µm inclusive.

4. Semiconductor chip according to at least one of the preceding claims,
**characterized in that**
the carrier layer (7) is different from the growth substrate (1) on which the semiconductor layer sequence (2, 20) for the thin-film semiconductor body (8) is grown epitaxially.

5. Semiconductor chip according to at least one of the preceding claims,
**characterized in that**
the carrier layer (7) is absorbent for the radiation generated in the active region (3).

6. Semiconductor chip according to at least one of the preceding claims,
**characterized in that**
the carrier layer (7) is embodied as a ceramic layer, polycrystalline layer or amorphous layer.

7. Semiconductor chip according to at least one of the preceding claims,
**characterized in that**
the carrier layer (7) contains an aluminum nitride or an aluminum oxide.

8. Semiconductor chip according to at least one of the preceding claims,
**characterized in that**
the carrier layer (7) has a multilayer structure.

9. Semiconductor chip according to at least one of the preceding claims,
**characterized in that**
a metal-containing layer (6), in particular a metal- or alloy-based layer, is arranged between the carrier layer (7) and the thin-film semiconductor body (8).

10. Semiconductor chip according to Claim 9,
**characterized in that**
the metal-containing layer (6) is formed as a mirror layer for radiation generated in the active region (3).

11. Semiconductor chip according to Claim 9 or 10,
**characterized in that**
the metal-containing layer (6) is embodied as a contact layer for making electrical contact with the semiconductor chip (12).

12. Semiconductor chip according to at least one of the preceding claims,
**characterized in that**
the semiconductor chip (10), in particular the semiconductor layer sequence (2, 20) and/or the active region (3), contains at least one III-V compound semiconductor material or is based on III-V compound semiconductor materials.

13. Semiconductor chip according to at least one of the preceding claims,
**characterized in that**
the semiconductor chip (12) is embodied as a resonator-free chip for generating incoherent radiation.

14. Semiconductor chip according to at least one of the preceding claims,
**characterized in that**
the semiconductor chip (12) is embodied as an LED chip.

15. Method for producing an optoelectronic semiconductor chip (12) comprising the steps of:
- providing a semiconductor layer sequence (2, 20) arranged on a substrate (1) for a semiconductor body (8) of the semiconductor chip, where the semiconductor layer sequence has an active region (3) suitable for generating radiation,
- forming an electrically insulating carrier layer (7) on the semiconductor layer sequence, and
- removing the substrate,
**characterized in that**
the carrier layer (7) is deposited on the semiconductor layer sequence (2, 20) by means of a deposition method.

16. Method according to Claim 15,
**characterized in that**
the carrier layer (7) is deposited on that side of the semiconductor layer sequence (2, 20) which is remote from the substrate (1).

17. Method according to Claim 15 or 16,
**characterized in that**
the carrier layer (7) is deposited on the semiconductor layer sequence (2, 20) by means of a PVD method or a CVD method.

18. Method according to at least one of Claims 15 to 17,
**characterized in that**
the carrier layer (7) is deposited on the semiconductor layer sequence (2, 20) by means of sputtering, in particular reactive sputtering, or a laser-assisted method, such as a deposition method using a pulsed laser, or vapor deposition.

19. Method according to at least one of Claims 15 to 18,
**characterized in that**
a metal-containing layer (6), in particular a metal- or alloy-based layer, is applied to that side of the semiconductor layer sequence (2, 20) which is remote from the substrate (1), prior to forming the carrier layer (7).

20. Method according to at least one of Claims 15 to 19,
**characterized in that**
the substrate (1) comprises the growth substrate on which the semiconductor layer sequence (2, 20) is grown epitaxially.

21. Method according to at least one of Claims 15 to 20,
**characterized in that**
the method is carried out for simultaneously producing a plurality of semiconductor chips (12) in the wafer assemblage.

22. Method according to Claim 21,
**characterized in that**
a side area (16) that delimits the carrier layer (7) of a semiconductor chip (12) produced by means of the method is formed during the singulation of the semiconductor chip from the wafer assemblage.

23. Method according to at least one of Claims 15 to 22,
**characterized in that**
a semiconductor chip (12) according to one of Claims 1 to 14 can be produced or is produced by means of the method.

## Revendications

1. Puce à semi-conducteurs (12) optoélectronique avec un corps semi-conducteur à film mince (8), le corps semi-conducteur à film mince comprenant une séquence de couches semi-conductrices (2, 20) avec une zone active (3) apte à la génération d'un rayonnement, où la séquence de couches semi-conductrices est cultivée de manière épitaxiale sur un substrat de croissance (1) en vue de provoquer sa croissance et où le substrat de croissance est aminci ou est extrait de la séquence de couches semi-conductrices, et avec une couche de support (7) qui stabilise mécaniquement le corps semi-conducteur à film mince et qui est formée sur la séquence de couches semi-conductrices, où la couche de support possède des propriétés d'isolation électrique,
**caractérisée en ce que**
la couche de support est une couche de support déposée sur la séquence de couches semi-conductrices.

2. Puce à semi-conducteurs selon la revendication 1
**caractérisée en ce que**
la couche de support (7) est conçue en porte à faux.

3. Puce à semi-conducteurs selon la revendication 1 ou 2
**caractérisée en ce que**
la couche de support (7) présente une épaisseur comprise entre 10 µm inclus et 500 µm inclus, et de préférence comprise entre 50 µm inclus et 200 µm inclus.

4. Puce à semi-conducteurs selon au moins l'une des revendications précédentes,
**caractérisée en ce que**
la couche de support (7) est différente du substrat de croissance (1) sur lequel la séquence de couches semi-conductrices (2, 20) est cultivée de manière épitaxiale, en vue de provoquer sa croissance, pour le corps semi-conducteur à film mince (8).

5. Puce à semi-conducteurs selon au moins l'une des revendications précédentes,
**caractérisée en ce que**
la couche de support (7) est absorbante pour le rayonnement généré dans la zone active (3).

6. Puce à semi-conducteurs selon au moins l'une des revendications précédentes,
**caractérisée en ce que**
la couche de support (7) est réalisée sous la forme d'une couche en céramique, d'une couche polycristalline ou d'une couche amorphe.

7. Puce à semi-conducteurs selon au moins l'une des revendications précédentes,
**caractérisée en ce que**
la couche de support (7) contient un nitrure d'aluminium ou une alumine.

8. Puce à semi-conducteurs selon au moins l'une des revendications précédentes,
**caractérisée en ce que**
la couche de support (7) présente une structure composée de plusieurs couches.

9. Puce à semi-conducteurs selon au moins l'une des revendications précédentes,
**caractérisée en ce que**
une couche (6) contenant du métal, en particulier une couche à base d'alliage ou de métal, est disposée entre la couche de support (7) et le corps semi-conducteur à film mince (8).

10. Puce à semi-conducteurs selon la revendication 9,
**caractérisée en ce que**
la couche (6) contenant du métal est conçue sous la forme d'une couche formant miroir pour le rayonnement généré dans la zone active (3).

11. Puce à semi-conducteurs selon la revendication 9 ou 10,
**caractérisée en ce que**
la couche (6) contenant du métal est réalisée comme une couche de contact en vue de la mise en contact électrique de la puce à semi-conducteurs (12).

12. Puce à semi-conducteurs selon au moins l'une des revendications précédentes,
**caractérisée en ce que**
la puce à semi-conducteurs (10), en particulier la séquence de couches semi-conductrices (2, 20) et/ou la zone active (3) contiennent au moins un matériau semi-conducteur composite issu de la colonne III - V ou qui est composé à base de matériaux semi-conducteurs composites issus de la colonne III - V.

13. Puce à semi-conducteurs selon au moins l'une des revendications précédentes,
**caractérisée en ce que**
la puce à semi-conducteurs (12) est réalisée comme une puce dépourvue de résonateur en vue de la génération d'un rayonnement incohérent.

14. Puce à semi-conducteurs selon au moins l'une des revendications précédentes,
**caractérisée en ce que**
la puce à semi-conducteurs (12) est réalisée comme une puce à DEL.

15. Procédé destiné à la production d'une puce à semi-conducteurs (12) optoélectronique, comprenant les phases suivantes :
- mise en place d'une séquence de couches semi-conductrices (2, 20), laquelle est disposée sur un substrat (1), pour un corps semi-conducteur (8) de la puce à semi-conducteurs, la séquence de couches semi-conductrices présentant une zone active (3) appropriée en vue de la génération d'un rayonnement ;
- formation d'une couche de support (7), laquelle possède des propriétés d'isolation électrique, sur la séquence de couches semi-conductrices ; et
- retrait du substrat ;
**caractérisé en ce que**
la couche de support (7) est déposée sur la séquence de couches semi-conductrices (2, 20) au moyen d'un procédé de dépôt.

16. Procédé selon la revendication 15,
**caractérisé en ce que**
la couche de support (7) est déposée, sur la face de la séquence de couches semi-conductrices (2, 20) étant opposée au substrat (1).

17. Procédé selon la revendication 15 ou 16,
**caractérisé en ce que**
la couche de support (7) est déposée sur la séquence de couches semi-conductrices (2, 20) au moyen d'un procédé en phase vapeur ou d'un procédé de dépôt chimique en phase vapeur.

18. Procédé selon au moins l'une des revendications 15 à 17,
**caractérisé en ce que**
la couche de support (7) est déposée sur la séquence de couches semi-conductrices (2, 20) au moyen d'une pulvérisation, en particulier d'une pulvérisation réactive, ou d'un procédé assisté par laser, tel que par exemple un procédé de dépôt en recourant à un laser pulsé, ou au moyen d'une vaporisation.

19. Procédé selon au moins l'une des revendications 15 à 18,
**caractérisé en ce que**
avant la formation de la couche de support (7), une couche (6) contenant du métal, en particulier une couche à base d'alliage ou de métal, est appliquée sur la face de la séquence de couches semi-conductrices (2, 20) étant opposée au substrat (1).

20. Procédé selon au moins l'une des revendications 15 à 19,
**caractérisé en ce que**
le substrat (1) comprend le substrat de croissance (1), sur lequel la séquence de couches semi-conductrices (2, 20) est cultivée de manière épitaxiale en vue de provoquer sa croissance.

21. Procédé selon au moins l'une des revendications 15 à 20,
**caractérisé en ce que**
le procédé destiné à la production simultanée d'une pluralité de puces à semi-conducteurs (12) est réalisé dans un composite en tranche.

22. Procédé selon la revendication 21,
**caractérisé en ce que**
une face latérale (16), délimitant la couche de support (7) d'une puce à semi-conducteurs (12) fabriquée au moyen du procédé, est formée lors de la séparation de la puce à semi-conducteurs hors du composite en tranche.

23. Procédé selon au moins l'une des revendications 15 à 22,
**caractérisé en ce que**
une puce à semi-conducteurs (12) est fabriquée ou peut être fabriquée au moyen du procédé, conformément à l'une des revendications 1 à 14.
